# EUROPEAN PATENT APPLICATION

(11) **EP 3 940 107 A1**
(43) Date of publication of application: **19.01.2022**
(21) Application number: 20770786.0
(22) Date of filing: 10.03.2020
(51) Int. Cl.: C23C 14/06, C23C 16/26, C23C 28/04, E21B 34/04, F16K 3/02

(54) **COMPOSITE MATERIAL WITH COATED DIFFUSED LAYER**

(30) Priority: 11.03.2019 BR 102019004737
(71) Applicant: FMC Technologies Do Brasil LTDA, 21941-615 Rio de Janeiro (BR)
(72) Inventor: ALVES, Fabio Pereira, 20725-232 Rio de Janeiro (BR); BRANDOLIN, Gustavo, 25716-132 Petrópolis (BR); BORGES, Raquel Silveira, 22775-033 Rio de Janeiro (BR); CARVALHO, Andréa Souza, 24220-401 Niterói (BR)
(74) Representative: Santarelli
(86) International application number: PCT/BR2020/050077
(87) International publication number: WO 2020/181347

(57) **Abstract**

The present invention relates to a composite material comprising a substrate that is thermochemically treated in order to harden the surface thereof and that is, therefore, not subject to deformations as a result of high stresses sustained by the outer layer; furthermore, the present invention further comprises an adhesion layer overlying the treated layer, subsequently, an intermediate layer and a DLC (Diamond Like Carbon) layer are added, wherein the DLC layer comprises a structure based on an amorphous carbon film. The present invention is intended to be used in valves built into submarine equipment. The composite material is thermochemically treated and comprises a treated substrate (2) and an adhesion layer (3) onto which is disposed an intermediate layer (4) that receives a final DLC layer (5). All of these layers, as shown, are disposed on the surface of a substrate (1) of a gate valve (6).

## Description

### Field of the Invention

The present invention relates to a new composite material comprising a substrate that is thermochemically treated in order to harden the surface thereof and that is, therefore, not subject to deformations as a result of high stresses sustained by the outer layer; furthermore, the present invention further comprises an adhesion layer overlying the treated layer, subsequently, an intermediate layer and a DLC (Diamond Like Carbon) layer are added, wherein the DLC layer comprises a structure based on an amorphous carbon film. The present invention is intended to be used in valves built into submarine equipment for oil exploration and production.

### Background of the Invention

Currently, some internal parts of the valves are coated with a hard coating which is responsible for promoting hardening of the surfaces and, consequently, giving resistance to abrasive and erosive wear to the parts (for example, seats, gate and rods). The hard coating consists of a tungsten carbide layer, with a thickness of around 150 µm, usually deposited by a thermal spray process, *e.g.,* high-velocity oxy-fuel (HVOF). This coating is endowed with high hardness and low porosity, when associated with the use of sealing, thus allowing the parts to function as sealing components, both for gas and liquids, under low- and highpressure conditions.

Since the contact pressures between the valve parts can reach extreme values, the thin coating can be removed as a consequence of a deformation in the treated substrate. Amorphous carbon coatings are known for their properties such as high hardness and low coefficient of friction. On the other hand, these coatings exhibit high residual stress, an intrinsic characteristic of this type of coating, and consequently a limiting factor for the viable film thickness. This limitation in the thickness of the amorphous carbon coating is a challenge for its application in valves, because an extremely hard thin film is not sufficient to withstand contact pressures and possible deformations of the treated substrate, resulting in leakage and/or valve failure.

One strategy to improve the performance of thin coatings is their use with a high hardness treated substrate, so that stress relief occurs due to the thin thickness of the thin coating, thus promoting an increase in deformation resistance of the treated substrate. Several references available in the literature state that the use of thermal/thermochemical treatments, such as carburizing or nitriding of low alloy-carbon steels, hardens the substrate, so that the reinforced substrate makes the coating more mechanically resistant, mainly avoiding and ensuring better adhesion of carbon films.

However, processes such as carburizing or nitriding used in low alloy-carbon steels are not effective for alloys with austenitic structure due to their metallurgical characteristics, and thus the present invention proposes a process designed specifically for metallic materials previously untreatable by such techniques, either by the formation of microstructures harmful to the mechanical/corrosion properties of the treated substrate or by the formation of brittle structures on the surface of the treated substrate, which would jeopardize the adhesion and thin film behavior and the corrosion resistance of the treated substrate and coating system.

The use of an amorphous carbon coating to reduce the coefficient of friction has been revealed in some documents, including materials with different layer arrangements according to the applications, such as, for example, gate valve for petroleum production or water injection (US9791051 B2) and (US 8146889 B2), valves of internal combustion engines (US 20140083387 A1), disc valve (EP1581758) and rocker arm (JP2008287727).

Document US 8146889 B2 discloses a gate valve with a DLC outer layer which is disposed on an intermediate coating, consisting of TiN, CrN, TiAl or other hardened material, said intermediate coating is deposited on the top of a layer hardened by a diffusion process, such as nitriding and carburizing. Said DLC outer layer has a thickness of from 2 to 8 micrometers, the intermediate coating of from 2 to 8 micrometers, which can reach 50 micrometers, and the hardened layer has 12.7 to 76.2 micrometers.

Document US 9791051 B2 discloses a gate valve with an outer layer of hydrogenated amorphous DLC, with a hydrogen content greater than 17%, said layer is disposed on a chromium carbide or nitride coating. Document US 9791051 B2 does not define the type of carbide used, which is a problem, since the selection of the material is extremely important as the function of this layer is to withstand the DLC and avoid the "eggshell effect" that occurs in said DLC layer, which is extremely hard and unable to deform.

Document US 20140083387 A1 discloses an engine valve (intake and exhaust valve) comprising a Si-DLC or SiO-DLC layer, said layer having a thickness of from 0.1 to 10 micrometers, Si-DLC or SiO-DLC layer is disposed on a CrN or WC intermediate layer, said layer having a thickness of from 0.1 to 5 micrometers, the intermediate layer is disposed on the top of a Cr or Ti bonding layer, said layer having a thickness of from 0.01 to 0.5 micrometers, and this layer is disposed on a substrate. The hardness and friction coefficient properties of the DLC layer depend on the intrinsic characteristics of the material constituting said DLC layer, and by the fact that it is doped by Si or SiO, the hardness and friction coefficient properties aforementioned are not ideal to be used in a gate valve. Furthermore, the DLC layer is not thick enough to withstand high contact stresses.

Document EP1581758 discloses a disc valve comprising a substrate, which may be stainless steel, a first layer which can be DLC or WC being disposed on the substrate followed by a chromium adhesion layer (21), a strengthening layer which can include DLC or WC and a DLC layer.

Document JP2008287727 discloses a coated rocker arm comprising a heat-treated substrate, with a chromium layer, a chromium-tungsten carbide layer and a DLC outer layer being disposed on this substrate, such that the DLC layer is not separated from the substrate by the abrasion subjected to the rocker arm.

However, these prior art documents reveal composite materials that are not technically adequate for coating applications of valve seats and gates used in oil exploration and production equipment, which require, in addition to improved performance, suitability and durability characteristics notably in relation to the deformations caused by the high stresses suffered by the outer layer in the working environment.

Therefore, the present invention relates to specific properties of using a thermochemical diffusion treatment for surface hardening in order to increase the resistance to deformation, and the addition of amorphous carbon-based coatings to reduce the coefficient of friction in valves that are used in oil production and exploration equipment.

In this regard, the present invention provides a new composite material structuring, suitable for coating valves, especially the gate valve, which has high-performance small thickness layers.

### Brief Description of the Invention

The present invention enables the use of a DLC layer (5) as a valve component coating, since it uses the diffusion treatment on the surface of the substrate (1), which can be the seat or the gate of a gate valve, but not limited to these components. The treated substrate (2) may be harder than the substrate (1), furthermore, heat treatment on the surface of the substrate can improve the adhesion characteristics and the ability to withstand higher adhesion pressures. The composite material (7) of the present disclosure may comprise a treated substrate (2), an adhesion layer (3) and an intermediate layer (4) between the treated substrate (2) and the DLC layer (5). Thus, the composite material (7) applied to the gate valves allows to reduce their actuating force, since there is a reduction in the coefficient of friction, and the composite material (7) increases the durability of said gate valves.

### Brief Description of the Figures

The composite material (7), object of the present invention, will be described with reference to the attached figures, which represent the scope thereof in a schematic and non-limiting form, as follows:
Figure 1 - Scheme of the layers of the composite material (7) in the embodiments of the present invention;
Figure 2 - Pictures of the test specimens (A) and (B) of the chemical compatibility test from the embodiments of the present invention;
Figure 3 - Plot of the coefficient of friction of the valves from the embodiments of the present invention;
Figure 4 - Plot of the coefficient of friction of the valves from the embodiments of the present invention;
Figure 5 - Plot of the sandless test under room temperature-cycling on the embodiments of the present invention;
Figure 6 - Plot of the sandless test under high temperature-cycling on the embodiments of the present invention;
Figure 7 - Plot of the sand test under room temperature-cycling on the embodiments of the present invention;
Figure 8 - Plot of the sand test under high temperature-cycling on the embodiments of the present invention;
Figure 9 - Picture of the upstream side of the gate after a thermal cycling sand test on the embodiments of the present invention;
Figure 10 - Picture of the downstream side of the gate after a thermal cycling sand test on the embodiments of the present invention;
Figure 11 - Picture of the upstream side of the seat after a thermal cycling sand test on the embodiments of the present invention;
Figure 12 - Picture of the downstream side of the seat after a thermal cycling sand test on the embodiments of the present invention.

### Detailed Description of the Invention

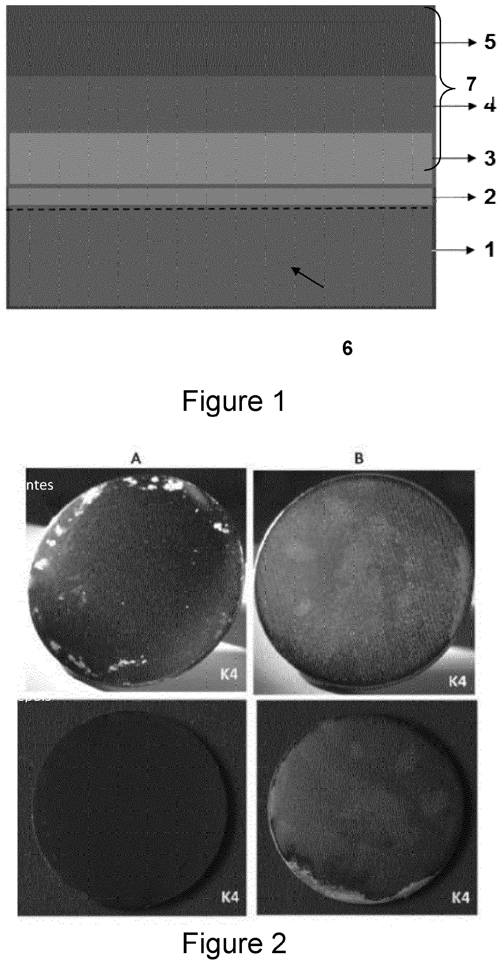

As can be seen in Figure 1, an example of the composite material (7) according to the present invention may comprise a treated substrate (2), an adhesion layer (3), onto which an intermediate layer (4) is disposed, wherein a DLC layer (5) is disposed on said intermediate layer (4), all these layers being disposed on the surface of the substrate (1) of a gate valve (6). It should be appreciated that this disclosure is not limited to this configuration, and modifications to the composite material (7) are possible within the scope of this disclosure.

### Treated Substrate (2)

The treated substrate (2) may be the outer surface of the substrate (1) composed of a metallic alloy with an austenitic structure, in one embodiment, the metallic alloy of the substrate (1) may be a nickel alloy. The thickness of the treated substrate (2) can be between 10 and 30 micrometers, the treated substrate (2) can be obtained by hardening, through a thermochemical diffusion treatment, the surface of the substrate (1) of a gate valve (6), wherein such hardening is preferably carried out by a process called Kolsterising, which is provided by the company BODYCOTE^{®}. The Kolsterising process is a low-temperature thermochemical process that provides hardening as a result of the formation of an expanded austenite due to the addition of carbon and/or nitrogen, in such a way that the treated substrate hardens without compromising its corrosion resistance properties. Furthermore, other low-temperature diffusion treatment processes could be used to harden the treated substrate (2), such as the Balitherm thermal process by OERLIKON^{®}; alternatively, mixing and friction process, such as Friction Stir Processing (FSP), could be used to harden the treated substrate (2).

In certain embodiments, after thermochemical treatment to obtain the treated substrate (2), a lapping post-process can alternatively be used to reduce the surface roughness of the treated substrate (2).

### Adhesion Layer (3)

In certain embodiments, an adhesion layer (3) can be added to the treated substrate (2). The use of the adhesion layer (3) can facilitate the addition of other intermediate layers (4), which can be composed of metallic materials. The adhesion layer (3) can be a thin layer of approximately 0.5 micrometers, and composed of chromium, silicon, or other suitable material. In a preferred embodiment, the adhesion layer (3) is composed of chromium.

### Intermediate Layer (4)

The intermediate layer (4) can be used in a composite material (7), *e.g.,* a high hardness gradient between the DLC film (5) and the adhesion layer (3). That is, the intermediate layer (4) can provide a support for the DLC film (5) which typically has a brittle characteristic. Furthermore, the intermediate layer (4) has the characteristic of being an additional barrier against corrosion between the treated substrate (2) and the external environment.

In certain embodiments, the intermediate layer (4) can comprise tungsten carbide (WC). In certain embodiments, including when the intermediate layer (4) comprises WC, the intermediate layer can be deposited by a physical vapor deposition (PVD) process, preferably by a magnetron sputtering process. The intermediate layer (4) can, but not essentially, have a minimum thickness of 20 micrometers and comprise typical hardness in the range of 27 to 30 Gpa. However, the WC layer can comprise a typical hardness lower than the range of 27 to 30 GPa, and be less brittle, and this is possible by choosing another deposition process, or even by changing the parameters/conditions in the deposition process, such as the introduction of gases during the process (*e.g*., acetylene).

### DLC Layer (5)

The outer layer of the composite material (7) can comprise a DLC layer (5) which is applied to the intermediate layer (4). The DLC layer (5) can be amorphous and characterized by having a low friction coefficient (0.05 - 0.2), preferably between 0.05 and 0.1, and higher hardness. In certain embodiments, DLC can be hydrogenated, with a hydrogen content of approximately 27%. Furthermore, the thickness of the DLC layer (5) can be at least 3 micrometers. It should be considered that the composition and configuration of the DLC layer (5) is not limited to the composition and configuration mentioned above. The DLC layer can comprise a typical hardness in the range of 22 to 25 Gpa.

In certain embodiments, the DLC layer (5) is deposited by a Chemical Vapor Deposition (CVD) process. In other embodiments, the DLC layer (5) can be deposited by processes such as Plasma-Enhanced Chemical Vapor Deposition (PECVD), or any other known deposition process that would be appreciated by a person skilled in the art.

In cases where the intermediate layer of WC is deposited by another deposition process, or wherein the PVD process is performed by changing parameters/conditions, the typical hardness of the intermediate layer (4) can be less hard and less brittle than the DLC layer (5). Likewise, the intermediate layer (4) can be less hard and more brittle than the adhesion layer (3) and the treated substrate (2).

### Tests with the Composite Material of the Invention

Composite material layers having characteristics similar to those described above were subjected to full-scale and specimen functional tests. The results of these tests are shown below. The tests were carried out in a closed loop system containing fluid with a given amount of sand (test set forth by standard /API 6AV1), wherein the closed-loop test subjects the composite material to distinct and aggressive conditions - Chemical compatibility test.

As can be seen in Figure 2, test specimens (A) and (B) were subjected to immersion tests in hydrochloric acid (HCI) and hydraulic oil at a high temperature (150°C) and for a period of 30 days, following the NACE/ISO15156 standard (level V test conditions for 30 days). In addition, test specimens (A) and (B) were subjected to assays under the pressure and temperature action (CO₂ and H₂S, at 150°C), and the composite material withstood all the tests mentioned above.

### Assessing the Coefficient of Friction in the Valves

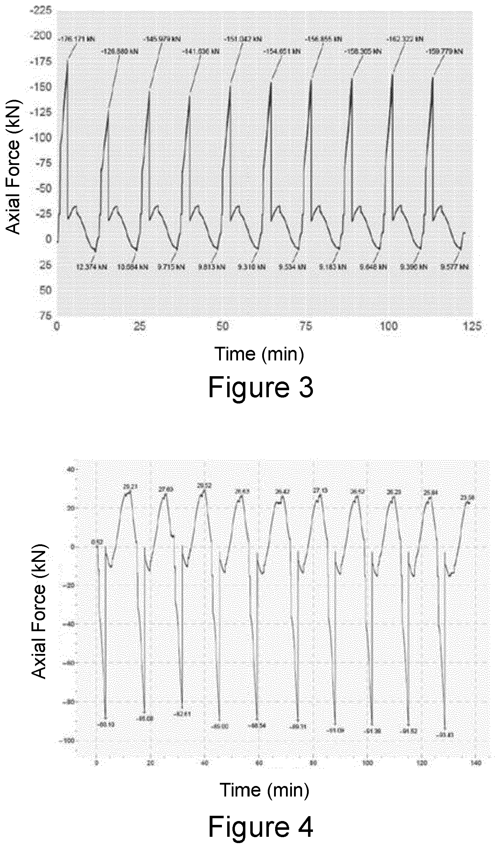

The coefficient of friction was measured directly in the composite material (7) in the valve by assessing the actuating forces in different actuating cycles. Figures 3 and 4 are the actuation curves (axial force against time) for the typical solution used by industry (WC coating added with cobalt (Co) by thermal spray) and the present invention comprising DLC. The coefficient of friction for the solution having WC-Co was 0.12, while the DLC showed a value much lower than 0.07.

### Closed-loop testing with sand-containing fluid associated with room temperature and high temperature cycling

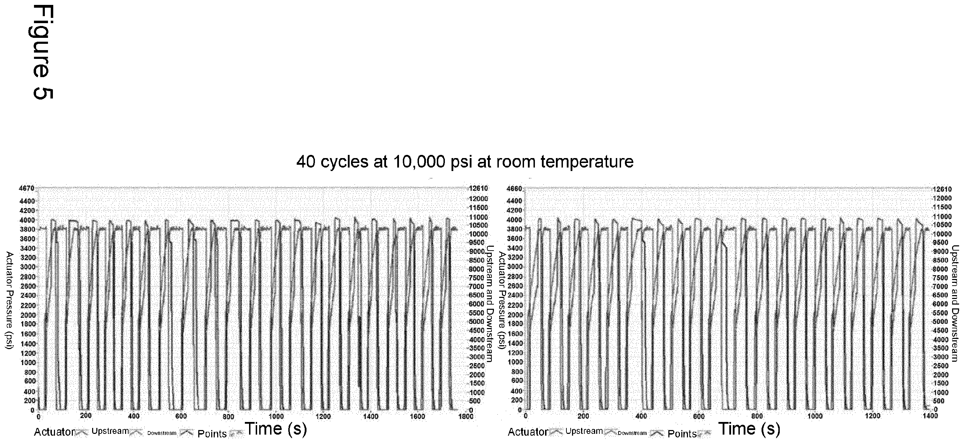

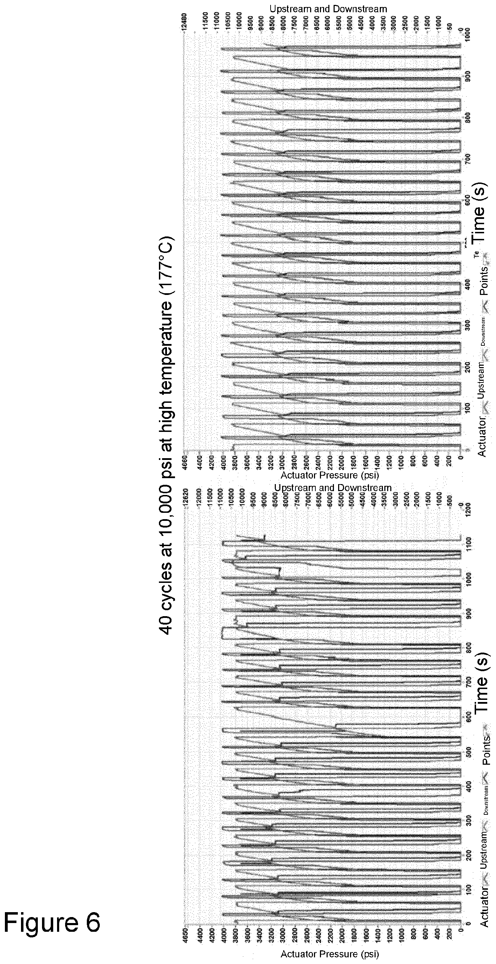

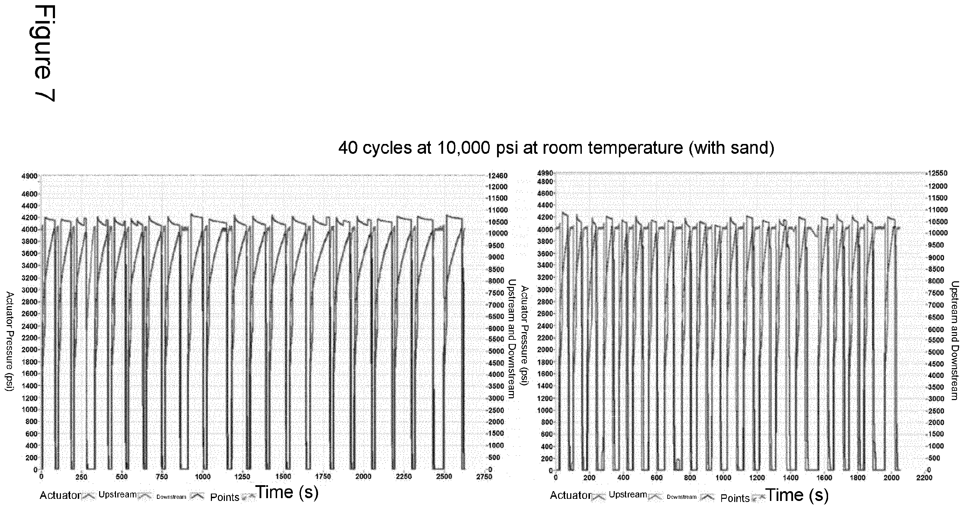

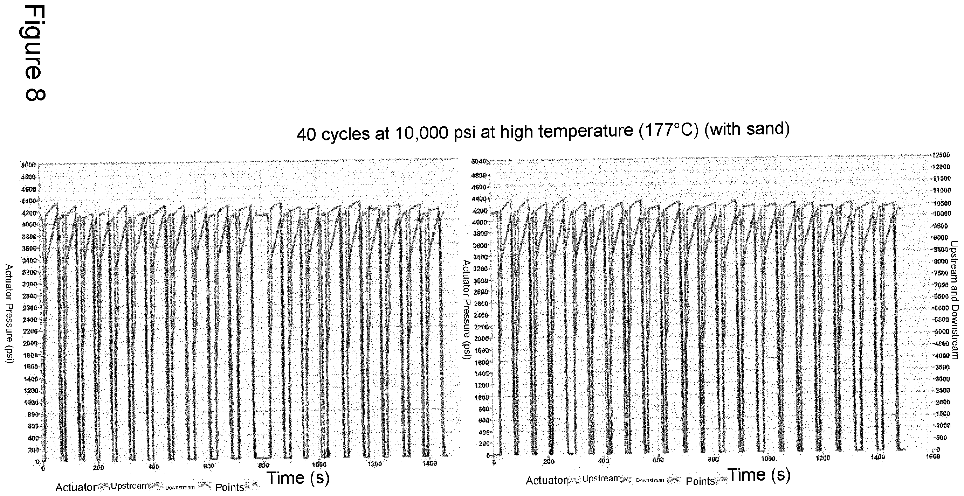

A cycling test was performed on the composite material (7), but the test set forth by API 6AV1 (sand slurry test) was modified to incorporate cycling before and after the sand test (extremely aggressive), by which the sealing capacity of the gate valve is checked in cycling performed at room temperature and 177°C. Figures 5, 6, 7 and 8 are the curves from the tests performed, wherein Figure 5 illustrates the sandless test in which 40 cycles are performed at a pressure of 10,000 PSI and at room temperature; Figure 6 illustrates the sandless test in which 40 cycles are performed at a pressure of 10,000 PSI and at high temperature (177°C); Figure 7 illustrates the sand test in which 40 cycles are performed at a pressure of 10,000 PSI and at room temperature and Figure 8 illustrates the sand test in which 40 cycles are performed at a pressure of 10,000 PSI and at high temperature (177°C).

As can be seen in Figures 5-8, the actuating curves in each of the steps demonstrate that the actuation curve (also called the valve signature) has not changed significantly. Furthermore, the valve sealed gas after all the steps described above, demonstrating the ability to maintain its functionality even after being subjected to the test conditions.

It is important to mention that, in addition to the evaluation of the "valve signature", the analysis of the parts after testing showed that even in the regions where the DLC coating (5) was removed from, the treated substrate was not exposed.

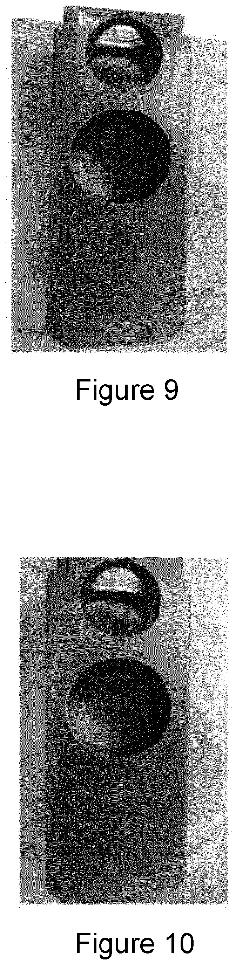

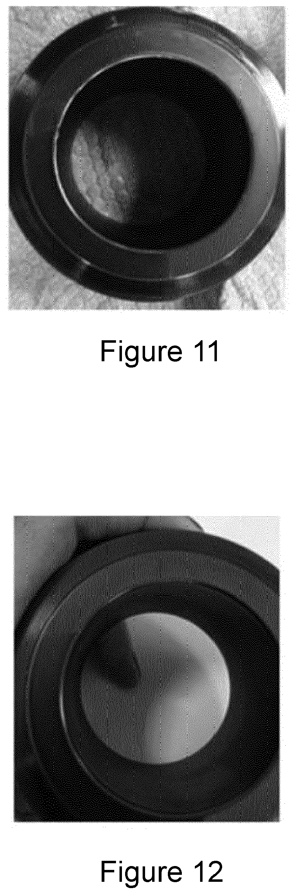

Figures 9 and 10 are pictures of the gates, and Figures 11 and 12 are pictures of the seats; these pictures showing the gates and seats after the tests performed to demonstrate the strength/durability of the parts coated by the composite material (7).

As will be appreciated by a person skilled in the art, the present invention affords the possibility of:
- decreasing the coefficient of friction using DLC under harsh conditions, such as abrasion, erosion and aggressive corrosive environment, and under high contact stresses; and
- increasing durability under typical environmental conditions of oil exploration and production operations when compared to the current solution employed by the industry.

## Claims

1. **COMPOSITE MATERIAL WITH COATED DIFFUSED LAYER,** for low-friction coating on valve seats and gates, **characterized in that** it comprises, in successive layers, a treated substrate (2), onto which an adhesion layer (3) is disposed and onto which an intermediate layer (4) supporting a final DLC layer (5) is disposed, wherein said treated substrate (2) is treated by a thermochemical diffusion process before receiving said adhesion layer (3).

2. **COMPOSITE MATERIAL WITH COATED DIFFUSED LAYER,** according to claim 1, **characterized in that** the treated substrate (2) is a layer external to the substrate (1), wherein said substrate (1) is an austenitic alloy.

3. **COMPOSITE MATERIAL WITH COATED DIFFUSED LAYER,** according to claim 2, **characterized in that** the austenitic alloy is a nickel alloy.

4. **COMPOSITE MATERIAL WITH COATED DIFFUSED LAYER,** according to claim 1, **characterized in that** the treated substrate (2) is alternatively lapped before the adhesion layer (3) is applied onto.

5. **COMPOSITE MATERIAL WITH COATED DIFFUSED LAYER,** according to claim 1, **characterized in that** the treated substrate (2) is formed by treating the substrate (1) with one of the thermochemical processes below: Kolsterising, Balitherm or mixing and friction thermomechanical process (FPS - Friction Stir Processing).

6. **COMPOSITE MATERIAL WITH COATED DIFFUSED LAYER,** according to claim 5, **characterized in that** the thermochemical treatment is Kolsterising.

7. **COMPOSITE MATERIAL WITH COATED DIFFUSED LAYER,** according to claim 1, **characterized in that** the adhesion layer (3) is chromium or silicon.

8. **COMPOSITE MATERIAL WITH COATED DIFFUSED LAYER,** according to claim 7, **characterized in that** the adhesion layer (3) is chromium.

9. **COMPOSITE MATERIAL WITH COATED DIFFUSED LAYER,** according to claim 1, **characterized in that** the intermediate layer (4) is tungsten carbide (WC).

10. **COMPOSITE MATERIAL WITH COATED DIFFUSED LAYER,** according to claim 1, **characterized in that** the intermediate layer (4) comprises typical hardness in the range of 22 to 25 Gpa.

11. **COMPOSITE MATERIAL WITH COATED DIFFUSED LAYER,** according to claims 1 or 9, **characterized in that** the intermediate layer (4) is deposited by physical vapor deposition (PVD) process.

12. **COMPOSITE MATERIAL WITH COATED DIFFUSED LAYER,** according to claim 10, **characterized in that** the physical vapor deposition (PVD) process is the magnetron sputtering process.

13. **COMPOSITE MATERIAL WITH COATED DIFFUSED LAYER,** according to claim 1, **characterized in that** the DLC layer (5) is the hydrogenated amorphous type and has a hydrogen content of approximately 27%.

14. **COMPOSITE MATERIAL WITH COATED DIFFUSED LAYER,** according to claim 1, **characterized in that** the DLC (5) is deposited by chemical vapor deposition (CVD) or plasma-enhanced chemical vapor deposition (PECVD).

15. **COMPOSITE MATERIAL WITH COATED DIFFUSED LAYER,** according to claim 1, **characterized in that** the DLC layer (5) comprises a typical hardness in the range of 22 to 25 Gpa.

16. **COMPOSITE MATERIAL WITH COATED DIFFUSED LAYER,** according to claim 1, **characterized in that** the DLC layer (5) comprises a coefficient of friction between 0.05 and 0.2.

17. **COMPOSITE MATERIAL WITH COATED DIFFUSED LAYER,** according to claim 16, **characterized in that** the DLC layer (5) comprises a coefficient of friction between 0.05 and 0.1.

18. **COMPOSITE MATERIAL WITH COATED DIFFUSED LAYER,** according to claim 1, **characterized in that** the thickness of the treated substrate (2) ranges from 10 to 30 micrometers, the thickness of the adhesion layer (3) is about 0.5 micrometer, the thickness of the intermediate layer (4) is at least 20 micrometers, and the thickness of the DLC layer (5) is at least 3 micrometers.
